# EUROPEAN PATENT APPLICATION

(11) **EP 4 660 652 A1**
(43) Date of publication of application: **10.12.2025**
(21) Application number: 23926527.5
(22) Date of filing: 06.11.2023
(51) Int. Cl.: G01R 31/396, G01R 31/382, G01R 31/367, G01R 31/392, G01R 31/385, G01R 19/12, G01R 19/175, G01R 19/165, B60R 16/033, B60L 58/12

(54) **BATTERY DATA MANAGEMENT DEVICE AND OPERATION METHOD THEREFOR**

(30) Priority: 06.03.2023 KR 20230029523
(71) Applicant: LG Energy Solution, Ltd., Seoul 07335 (KR)
(72) Inventor: CHUN, Joo Young, Daejeon 34122 (KR); KOH, Dong Wook, Daejeon 34122 (KR); JUN, Gwang Hoon, Daejeon 34122 (KR)
(74) Representative: Plasseraud IP
(86) International application number: PCT/KR2023/017648
(87) International publication number: WO 2024/185954

(57) **Abstract**

A battery data management apparatus according to an embodiment disclosed herein includes a communication module configured to receive battery data from a vehicle and a controller configured to generate voltage change information with respect to state of charge (SOC)-specific charging/discharging rate (C-rate) by dividing the battery data based on an SOC range and generate open circuit voltage (OCV) change information with respect to an SOC by using the voltage change information with respect to the SOC-specific charging/discharging rate.

## Description

### [Technical Field]

### CROSS-REFERENCE TO RELATED APPLICATION

This application claims priority to and the benefit of Korean Patent Application No. 10-2023-0029523 filed in the Korean Intellectual Property Office on March 6, 2023, the entire content of which is incorporated herein by reference.

### TECHNICAL FIELD

Embodiments disclosed herein relate to a battery data management apparatus and an operating method thereof.

### [Background Art]

An electric vehicle is supplied with electricity from outside to charge a battery cell, and then a motor is driven by a voltage charged in the battery cell to obtain power. The battery cell of the electric vehicle may have heat generated therein by chemical reaction occurring in a process of charging and discharging electricity, and the heat may impair performance and lifetime of the battery cell.

As battery cells are repeatedly used and charged and discharged, they age, their lives are gradually shortened. The lifetime of the battery cell is greatly affected by conditions such as a use temperature, a use period, a charging voltage, the number of times of discharging, etc., and thus may not be accurately diagnosed merely by measuring the remaining capacity of the battery cell. Thus, to estimate the remaining lifetime of the battery, a process of calculating an accurate open circuit voltage (OCV) of the battery is required.

However, conventional methods of calculating an OCV of a battery include measuring a voltage behavior of the battery by directly removing the battery mounted on a vehicle or performing charging/discharging experiment on the battery with a specific pattern using a separate charging/discharging device, and these methods need a long time and resources for OCV measurement.

### [Disclosure]

### [Technical Problem]

Embodiments disclosed herein aim to provide a battery data management apparatus and an operating method thereof, in which accurate OCV data of a battery may be obtained to estimate the lifetime of the battery.

Technical problems of the embodiments disclosed herein are not limited to the above-described technical problems, and other unmentioned technical problems would be clearly understood by one of ordinary skill in the art from the following description.

### [Technical Solution]

A battery data management apparatus according to an embodiment disclosed herein includes a communication module configured to receive battery data from a vehicle and a controller configured to generate voltage change information with respect to state of charge (SOC)-specific charging/discharging rate (C-rate) by dividing the battery data based on an SOC range and generate open circuit voltage (OCV) change information with respect to an SOC by using the voltage change information with respect to the SOC-specific charging/discharging rate.

According to an embodiment, the communication module may be further configured to receive the battery data from a data collecting device that collects the battery data of the vehicle.

According to an embodiment, the controller may be further configured to arrange the battery data at specific intervals based on the SOC by applying interpolation to the battery data.

According to an embodiment, the controller may be further configured to generate an SOC-specific data group by dividing the battery data based on an SOC range and generate voltage change information according to the SOC-specific charging/discharging rate by fitting each SOC-specific data group.

According to an embodiment, the controller may be further configured to calculate the SOC-specific OCV by extracting an OCV that is a voltage value for a charging/discharging rate of '0' from the voltage change information according to the SOC-specific charging/discharging rate.

According to an embodiment, the controller may be further configured to generate OCV change information with respect to the SOC by processing an OCV included in the voltage change information according to the SOC-specific charging/discharging rate.

According to an embodiment, the controller may be further configured to generate OCV change information with respect to the SOC by inputting the SOC-specific OCV to a window filter to smooth the SOC-specific OCV.

An operating method of a battery data management apparatus includes receiving battery data from a vehicle, generating voltage change information with respect to a state of charge (SOC)-specific charging/discharging rate C-rate by dividing the battery data based on an SOC range, and generating open circuit voltage (OCV) change information with respect to an SOC by using the voltage change information with respect to the SOC-specific charging/discharging rate.

According to an embodiment, the receiving of the battery data from the vehicle may include receiving the battery data from a data collecting device that collects the battery data of the vehicle.

According to an embodiment, the generating of the voltage change information with respect to the SOC-specific charging/discharging rate (C-rate) by dividing the battery data based on the SOC range may include arranging the battery data at specific intervals based on the SOC by applying interpolation to the battery data.

According to an embodiment, the generating of the voltage change information with respect to the SOC-specific charging/discharging rate (C-rate) by dividing the battery data based on the SOC range may include generating an SOC-specific data group by dividing the battery data based on the SOC range and generate voltage change information according to the SOC-specific charging/discharging rate by fitting each SOC-specific data group.

According to an embodiment, the generating of the voltage change information with respect to the SOC-specific charging/discharging rate (C-rate) by dividing the battery data based on the SOC range may include calculating the SOC-specific OCV by extracting an OCV that is a voltage value for a charging/discharging rate of '0' from the voltage change information according to the SOC-specific charging/discharging rate.

According to an embodiment, the generating of the voltage change information with respect to the SOC-specific charging/discharging rate (C-rate) by dividing the battery data based on the SOC range may include generating OCV change information with respect to the SOC by processing an OCV included in the voltage change information according to the SOC-specific charging/discharging rate.

According to an embodiment, the generating of the voltage change information with respect to the SOC-specific charging/discharging rate (C-rate) by dividing the battery data based on the SOC range may include generating OCV change information with respect to the SOC by inputting the SOC-specific OCV to a window filter to smooth the SOC-specific OCV.

### [Advantageous Effects]

With a battery data management apparatus and an operating method thereof according to an embodiment disclosed herein, accurate OCV data of a battery may be obtained to estimate the lifetime of the battery.

### [Description of Drawings]

FIG. 1 illustrates a battery pack according to an embodiment disclosed herein.
FIG. 2 is a block diagram showing a configuration of a battery data management apparatus according to an embodiment disclosed herein.
FIG. 3 is a graph showing battery data according to an embodiment disclosed herein.
FIG. 4 is a graph showing voltage change information with respect to a charging/discharging rate for each SOC, according to an embodiment disclosed herein.
FIG. 5 is a graph showing OCV change information with respect to an SOC, according to an embodiment disclosed herein.
FIG. 6 is a graph showing OCV change information with respect to an SOC, according to another embodiment disclosed herein.
FIG. 7 is a flowchart showing an operating method of a battery data management apparatus, according to an embodiment disclosed herein.
FIG. 8 is a block diagram showing a hardware configuration of a computing system for performing an operating method of a battery data management apparatus, according to an embodiment disclosed herein.

### [Mode for Invention]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

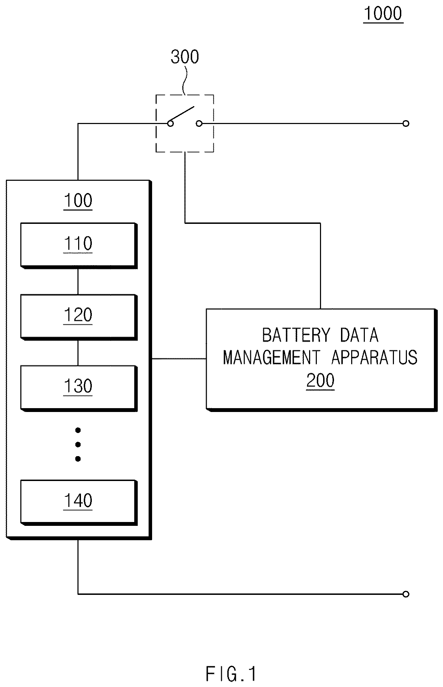

FIG. 1 illustrates a battery pack according to an embodiment disclosed herein.

Referring to FIG. 1, a battery pack 1000 according to an embodiment disclosed herein may include a battery module 100, a battery data management apparatus 200, and a relay 300. According to various embodiments, the battery module 100 may be a battery cell, and in this case, the battery pack 1000 may have a cell-to-pack structure.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

According to an embodiment, the battery data management apparatus 200 may be implemented in the form of a battery management system (BMS). Moreover, according to an embodiment, the battery data management apparatus 200 may be mounted on a battery management system.

The battery data management apparatus 200 may predict a lifetime, i.e., a state of health (SOH), of the plurality of battery cells 110, 120, 130, and 140 based on temperature and voltage data of the plurality of battery cells 110, 120, 130, and 140. The battery data management apparatus 200 may remove nose of battery data of the plurality of battery cells 110, 120, 130, and 140, and predict the SOH of the plurality of battery cells 110, 120, 130, and 140 based on data from which the noise is removed.

The battery data management apparatus 200 may manage and/or control a state and/or an operation of the battery module 100. For example, the battery data management apparatus 200 may manage and/or control the states and/or operations of the plurality of battery cells 110, 120, 130, and 140 included in the battery module 100. The battery data management apparatus 200 may manage charging and/or discharging of the battery module 100.

The battery data management apparatus 200 may control an operation of the relay 300. For example, the battery data management apparatus 200 may short-circuit the relay 300 to supply power to the target device. The battery data management apparatus 200 may short-circuit the relay 300 when a charging device is connected to the battery pack 1000.

In addition, the battery data management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery data management apparatus 200, which are not shown, may be additionally installed in the battery module 100, a charging/discharging path, any position of the battery module 100, etc. The battery data management apparatus 200 may calculate a parameter indicating a state of the battery module 100, e.g., a state of charge (SOC), based on a measurement value such as monitored voltage, current, temperature, etc.

The battery data management apparatus 200 may estimate a degradation factor of each of a positive electrode and a negative electrode separately for a state of the positive electrode and the negative electrode of the battery to evaluate an SOH of the battery, i.e., the lifetime of the battery. In this case, the battery data management apparatus 200 may analyze an open circuit voltage (OCV) of the battery to estimate a degradation factor of each of the positive electrode and the negative electrode of the battery. Herein, the OCV may mean a voltage measured when the current of the battery does not flow. The OCV may be a voltage between both electrodes in a state where a fuel electrode (anode) and an air electrode (cathode) of the battery are not electrically connected to each other. According to the Ohm's law, as the battery's resistance increases infinitely, the current may approach '0', thereby accurately measuring a voltage of the battery. Thus, the battery data management apparatus 200 may measure and analyze the OCV of the battery for accurate electrochemical analysis of the battery.

The battery data management apparatus 200 may analyze a degradation factor of each of the positive electrode and the negative electrode, such as a loss of lithium inventory (LLI), a loss of active material-negative electrode (LAMn), a loss of active material-positive electrode (LAMp), etc., by differentiating the OCV of the battery. Herein, the LLI, which is a loss of lithium inventory, means how much lithium of the battery cell decreases with respect to BOL, the LAMn means how much the positive electrode active material of the battery decreases with respect to BOL, and the LAMp means how much the negative electrode active material of the battery decreases with respect to BOL. For example, the battery data management apparatus 200 may extract the LLI, the LAMn, or the LAMp, which is the degradation factor of the battery, by using an artificial intelligence model for analyzing the OCV of the battery or a mathematical modeling technique for calculating the degradation factor of the battery.

The battery data management apparatus 200 may calculate an OCV graph of the battery based on battery data measured through actual driving of the vehicle. The battery data management apparatus 200 may derive a continuous OCV curve of the battery by analyzing and processing the battery data measured through actual driving of the vehicle.

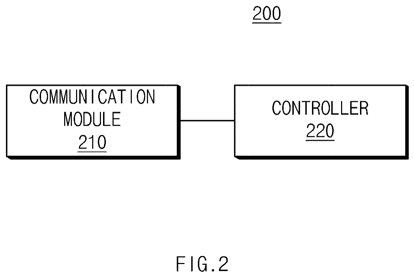

FIG. 2 is a block diagram showing a configuration of a battery data management apparatus according to an embodiment disclosed herein.

Hereinbelow, a configuration of the battery data management apparatus 200 will be described in detail with reference to FIG. 2.

Referring to FIG. 2, the battery data management apparatus 200 may include a communication module 210 and a controller 220.

The communication module 210 may receive battery data of the vehicle from the vehicle. According to an embodiment, the communication module 210 may receive battery data from a data collecting device (not shown) that collects the battery data of the vehicle. The data collecting device may be connected to the vehicle (not shown) having a battery pack mounted thereon to collect battery data generated by actual driving of the vehicle. The data collecting device may collect the battery data generated from various sensors or controllers in the vehicle. Herein, the battery data may include, as information regarding the battery mounted on the vehicle, a charging/discharging rate C-rate, a voltage V, a current I, a temperature T, a capacity Q, an SOC, etc., of the battery. According to an embodiment, the data collecting device may include on-board diagnostics (OBD). The OBD may be an electronic device capable of measuring and diagnosing the state of the vehicle and collecting the battery data.

The communication module 210 may be connected to the data collecting device through a wired/wireless network. For example, the communication module 210 may be connected to the data collecting device through Bluetooth, WiFi, ZigBee, controller area network (CAN) communication, or Ethernet communication.

According to an embodiment, the communication module 210 may be connected to a plurality of data collecting devices. According to an embodiment, the communication module 210 may be simultaneously connected to the plurality of data collecting devices to simultaneously obtain battery data of the vehicle collected by each of the plurality of data collecting devices.

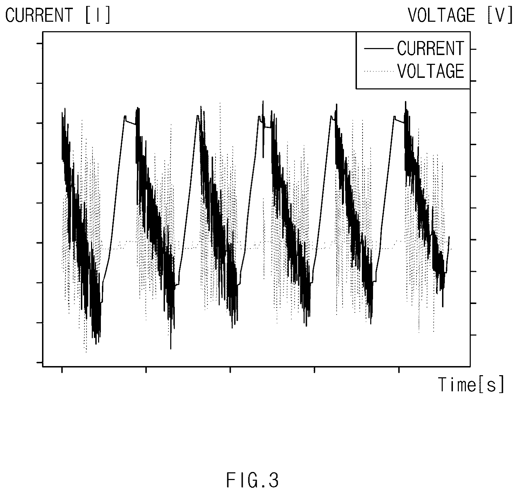

FIG. 3 is a graph showing battery data according to an embodiment disclosed herein.

Referring to FIG. 3, the communication module 210 may obtain battery data collected during the entire driving period of the vehicle from the data collecting device. Herein, the battery data may include the voltage V and the current I of the battery, collected during the entire driving period of the vehicle. According to an embodiment, the communication module 210 may obtain battery data collected during the same period from the data collecting device.

The controller 220 may apply interpolation to the battery data to arrange the battery data at specific intervals based on SOC. Herein, interpolation, which is a method of standardizing given data in the form of a polynomial, may estimate data that is not obtained through observation or experiment. The battery data obtained from the data collecting device by the communication module 210 may include voltage data corresponding to different SOC values. That is, the battery data obtained from the data collecting device may form discontinuous data distribution when arranged based on the SOC values. Thus, the controller 220 may apply interpolation to the battery data to analyze a change trend of SOC included in the battery data. That is, the controller 220 may correct the battery data to be arranged at specific intervals based on SOC using interpolation, thereby generating continuous battery data.

According to an embodiment, the controller 220 may generate voltage V change information with respect to an SOC of the battery by using the battery data corrected using interpolation. That is, the controller 220 may generate an SOC-V profile. According to an embodiment, the controller 220 may generate the voltage change information with respect to the SOC of the battery and plot the same on a display (not provided).

The controller 220 may divide the battery data by an SOC range to generate an SOC-specific data group. More specifically, the controller 220 may group, into a plurality of groups, the battery data arranged based on SOC using interpolation.

According to an embodiment, the controller 220 may divide the battery data based on the SOC range to generate the SOC-specific data group, and generate a data frame by using the SOC-specific data group. Herein, the data frame may mean a data list in a rectangular shape including columns and rows of data. The controller 220 may generate the SOC-specific data frame by processing the battery data included in the SOC-specific data group. The data frame may include voltage, current, and charging/discharging rate C-rate data of the battery. For example, the controller 220 may extract battery data with an SOC value ranging from 0 to 0.1 from the battery data, and generate a data frame by using a voltage, a current, and a C-rate of the battery included in the battery data.

The controller 220 may generate voltage change information with respect to an SOC-specific charging/discharging rate.

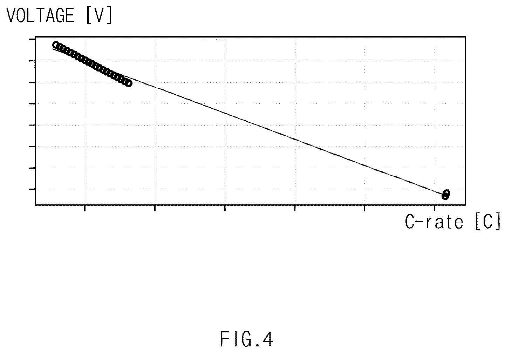

FIG. 4 is a graph showing voltage change information with respect to a charging/discharging rate for each SOC, according to an embodiment disclosed herein.

Referring to FIG. 4, the controller 220 may fit each SOC-specific data group. More specifically, the controller 220 may perform polynomial curve fitting on each SOC-specific data group generated by dividing the battery data based on the SOC range. Herein, polynomial curve fitting is a method of fitting data as a polynomial curve rather than a linear curve because when a relationship between a number of pieces of data are calculated, it may not be expressed as a simple proportional relationship. The controller 220 may perform polynomial curve fitting on the voltage V and the charging/discharging rate C-rate data of the battery, included in each SOC-specific data group, thereby generating the voltage V change information with respect to the charging/discharging rate C-rate of the battery.

That is, the controller 220 may perform polynomial curve fitting on the voltage V and the charging/discharging rate C-rate data of the battery, included in each of a plurality of SOC-specific data groups, thereby generating a trend line of the data.

According to an embodiment, the controller 220 may fit each SOC-specific data group to calculate a voltage change function with respect to an SOC-specific charging/discharging rate. More specifically, the controller 220 may calculate a voltage change function with respect to an SOC-specific charging/discharging rate by using a polynomial regression artificial intelligence model. The controller 220 may analyze the trend line obtained by performing polynomial curve fitting on the voltage V and the charging/discharging rate C-rate data of the battery, included in each of the plurality of SOC-specific data groups, thereby generating a polynomial indicating a correlation between the data. For example, the controller 220 may analyze the trend line generated by fitting the voltage V change data with respect to the charging/discharging rate C-rate of the battery included in a data group corresponding to an SOC value ranging from 0 to 0.1, thereby calculating '(-0.00)*x*²+(-0.01)*x*+3.45' as a voltage change function with respect to a charging/discharging rate.

The controller 220 may calculate an SOC-specific OCV by using the voltage change function with respect to the SOC-specific charging/discharging rate. The controller 220 may use '0' C-rate interpolation that searches for a point at which an X coordinate is '0' in the voltage change function with respect to the SOC-specific charging/discharging rate. That is, the controller 220 may calculate an SOC-specific OCV by extracting an OCV that is a voltage value when a charging/discharging rate, which is an X coordinate, is '0' in the voltage change function with respect to the SOC-specific charging/discharging rate.

For example, the controller 220 may calculate the voltage change function ' (-0.00)*x*²+(-0.01)*x*+3.45' with respect to the charging/discharging rate of a data group with an SOC value ranging from 0 to 0.1, and then calculate, as '3.45', an OCV value that is a voltage value when the charging/discharging rate C-rate, which is an X coordinate in the voltage change function, is '0'.

The controller 220 may generate OCV change information with respect to an SOC by using a voltage change function with respect to an SOC-specific charging/discharging rate.

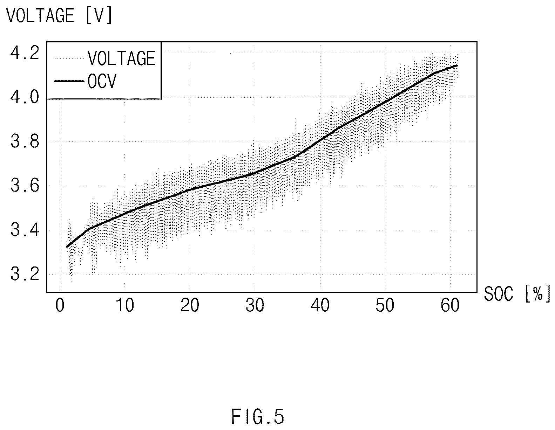

FIG. 5 is a graph showing OCV change information with respect to an SOC, according to an embodiment disclosed herein.

Referring to FIG. 5, the controller 220 may generate OCV change information with respect to the SOC by connecting SOC-specific OCVs calculated through the voltage change function with respect to the SOC-specific charging/discharging rate. That is, the controller 220 may generate OCV change information with respect to the SOC of the battery by processing the voltage change information with respect to the SOC-specific charging/discharging rate.

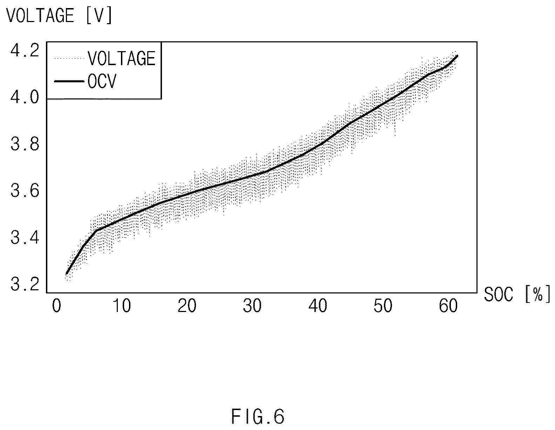

FIG. 6 is a graph showing OCV change information with respect to an SOC, according to another embodiment disclosed herein.

Referring to FIG. 6, the controller 220 may input the SOC-specific OCV information to a window-based filter to smooth the SOC-specific OCV information, thus removing noise of OCV change information with respect to the SOC. That is, the controller 220 may smooth the SOC-specific OCV information by inputting the SOC-specific OCV information to the window-based filter. The controller 220 may smooth a continuous OCV curve from which noise is removed, by smoothing the SOC-specific OCV information.

According to an embodiment, the controller 220 may perform polynomial curve fitting on the OCV change information with respect to the SOC. The controller 220 may perform polynomial curve fitting on the OCV change information with respect to the SOC to generate a trend line of the data.

According to an embodiment, the controller 220 may perform polynomial curve fitting on the OCV change information with respect to the SOC to generate a polynomial indicating a correlation. More specifically, the controller 220 may analyze a trend line of the OCV change information with respect to the SOC by using a polynomial regression artificial intelligence model to calculate an OCV change function with respect to the SOC.

As described above, with the battery data management apparatus 200 according to an embodiment disclosed herein, it is possible to generate an accurate OCV graph of the battery for lifetime estimation of the battery by using battery data obtained through actual driving of the vehicle.

The battery data management apparatus 200 may not need a time for charging and discharging the battery in a specific pattern by generating the OCV graph of the battery through the battery data obtained by driving of the vehicle, and may analyze a large volume of battery data within a short time.

A short time is required for calculation of the OCV of the battery, and when the battery is diagnosed as being in an abnormal state by constantly determining the state thereof the user may be immediately provided with information.

Moreover, the battery data management apparatus 200 may accurately diagnose the state of the battery by obtaining the noise-removed battery data and improve the accuracy of prediction of the lifetime of the battery.

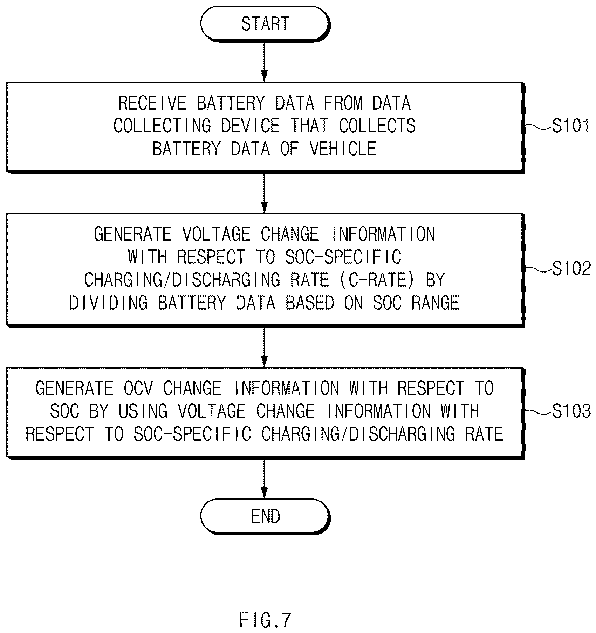

FIG. 7 is a flowchart showing an operating method of a battery data management apparatus, according to an embodiment disclosed herein.

The battery data management apparatus 200 may be substantially the same as the battery data management apparatus 200 described with reference to FIGS. 1 to 6, and thus will be briefly described to avoid redundant description.

Referring to FIG. 7, the operating method of the battery data management apparatus 200 may include operation S101 of receiving battery data from a data collecting device that collects battery data of a vehicle, operation S102 of generating voltage change information with respect to an SOC-specific charging/discharging rate C-rate by dividing the battery data based on an SOC range, and operation S103 of generating OCV change information with respect to the SOC by using the voltage change information with respect to the SOC-specific charging/discharging rate.

In operation S101, the communication module 210 may receive the battery data from the data collecting device (not shown) that collects the battery data of the vehicle. The data collecting device may be connected to the vehicle (not shown) having a battery pack mounted thereon to collect battery data generated by actual driving of the vehicle. Herein, the battery data may include, as information regarding the battery mounted on the vehicle, a charging/discharging rate C-rate, a voltage V, a current I, a temperature T, a capacity Q, an SOC, etc., of the battery. According to an embodiment, the data collecting device may include on-board diagnostics (OBD). The OBD may be an electronic device capable of measuring and diagnosing the state of the vehicle and collecting the battery data.

In operation S101, the communication module 210 may be connected to a plurality of data collecting devices. In operation S101, the communication module 210 may be simultaneously connected to the plurality of data collecting devices to simultaneously obtain battery data of the vehicle collected by each of the plurality of data collecting devices.

In operation S101, the communication module 210 may obtain battery data collected during the entire driving period of the vehicle from the data collecting device. Herein, the battery data may include the voltage V and the current I of the battery, collected during the entire driving period of the vehicle.

In operation S101, according to an embodiment, the communication module 210 may obtain battery data collected during the same period from the data collecting device.

In operation S102, the controller 220 may apply interpolation to the battery data to arrange the battery data at specific intervals based on the SOC. Herein, interpolation, which is a method of standardizing given data in the form of a polynomial, may estimate data that is not obtained through observation or experiment.

In operation S102, the controller 220 may correct the battery data to be arranged at specific intervals based on the SOC using interpolation, thereby generating continuous battery data.

In operation S102, according to an embodiment, the controller 220 may generate voltage V change information with respect to the SOC of the battery by using the battery data corrected using interpolation. In operation S102, the controller 220 may generate an SOC-V profile. In operation S102, according to an embodiment, the controller 220 may generate the voltage change information with respect to the SOC of the battery and plot the same on a display (not provided).

In operation S102, the controller 220 may divide the battery data by an SOC range to generate an SOC-specific data group. More specifically, the controller 220 may group, into a plurality of groups, the battery data arranged based on the SOC using interpolation.

In operation S102, according to an embodiment, the controller 220 may divide the battery data based on the SOC range to generate the SOC-specific data group, and generate a data frame by using the SOC-specific data group. Herein, the data frame may mean a data list in a rectangular shape including columns and rows of data. In operation S102, the controller 220 may generate the SOC-specific data frame by processing the battery data included in the SOC-specific data group. The data frame may include voltage, current, and charging/discharging rate C-rate data of the battery.

In operation S102, the controller 220 may fit each SOC-specific data group. In operation S102, more specifically, the controller 220 may perform polynomial curve fitting on each SOC-specific data group generated by dividing the battery data based on the SOC range. Herein, polynomial curve fitting is a method of fitting data as a polynomial curve rather than a linear curve because when a relationship between a number of pieces of data are calculated, it may not be expressed as a simple proportional relationship. In operation S102, the controller 220 may perform polynomial curve fitting on the voltage V and the charging/discharging rate C-rate data of the battery, included in each SOC-specific data group, thereby generating the voltage V change information with respect to the charging/discharging rate C-rate of the battery.

In operation S102, that is, the controller 220 may perform polynomial curve fitting on the voltage V and the charging/discharging rate C-rate data of the battery, included in each of a plurality of SOC-specific data groups, thereby generating a trend line of the data.

In operation S102, according to an embodiment, the controller 220 may fit each SOC-specific data group to calculate a voltage change function with respect to an SOC-specific charging/discharging rate. In operation S102, more specifically, the controller 220 may calculate a voltage change function with respect to an SOC-specific charging/discharging rate by using a polynomial regression artificial intelligence model. In operation S102, the controller 220 may analyze the trend line obtained by performing polynomial curve fitting on the voltage V and the charging/discharging rate C-rate data of the battery, included in each of the plurality of SOC-specific data groups, thereby generating a polynomial indicating a correlation between the data.

In operation S103, the controller 220 may calculate an SOC-specific OCV by using the voltage change function with respect to the SOC-specific charging/discharging rate. In operation S103, the controller 220 may use '0' C-rate interpolation that searches for a point at which an X coordinate is '0' in the voltage change function with respect to the SOC-specific charging/discharging rate. In operation S103, that is, the controller 220 may calculate an SOC-specific OCV by extracting an OCV that is a voltage value when a charging/discharging rate, which is an X coordinate, is '0' in the voltage change function with respect to the SOC-specific charging/discharging rate.

In operation S103, the controller 220 may generate OCV change information with respect to the SOC by using a voltage change function with respect to an SOC-specific charging/discharging rate. In operation S103, the controller 220 may generate OCV change information with respect to the SOC by connecting SOC-specific OCVs. In operation S103, that is, the controller 220 may generate OCV change information with respect to the SOC of the battery by processing the voltage change information with respect to the SOC-specific charging/discharging rate.

In operation S103, the controller 220 may input the SOC-specific OCV information to a window-based filter to smooth the SOC-specific OCV information, thus removing noise of OCV change information with respect to the SOC. In operation S103, that is, the controller 220 may smooth the SOC-specific OCV information by inputting the SOC-specific OCV information to the window-based filter. In operation S103, the controller 220 may smooth a continuous OCV curve from which noise is removed, by smoothing the SOC-specific OCV information.

In operation S103, according to an embodiment, the controller 220 may perform polynomial curve fitting on the OCV change information with respect to the SOC. In operation S103, the controller 220 may perform polynomial curve fitting on the OCV change information with respect to the SOC to generate a trend line of the data.

In operation S103, according to an embodiment, the controller 220 may perform polynomial curve fitting on the OCV change information with respect to the SOC to generate a polynomial indicating a correlation. In operation S103, more specifically, the controller 220 may analyze a trend line of the OCV change information with respect to the SOC by using a polynomial regression artificial intelligence model to calculate an OCV change function with respect to the SOC.

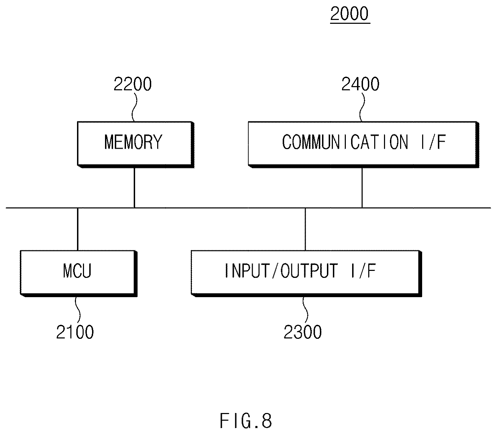

FIG. 8 is a block diagram showing a hardware configuration of a computing system for performing an operating method of a battery data management apparatus, according to an embodiment disclosed herein.

Referring to FIG. 8, a computing system 2000 according to an embodiment disclosed herein may include an MCU 2100, a memory 2200, an input/output I/F 2300, and a communication I/F 2400.

The MCU 2100 may be a processor that executes various programs (e.g., an OCV calculation algorithm, etc.) stored in the memory 2200, processes various data through these programs, and perform the above-described functions of the battery data management apparatus 200 shown in FIG. 1.

The memory 2200 may store various programs regarding operations of the battery data management apparatus 200. Moreover, the memory 2200 may store operation data of the battery data management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

As such, a computer program according to an embodiment disclosed herein may be recorded in the memory 2200 and processed by the MCU 2100, thus being implemented as a module that performs respective functions of the battery data management apparatus 200 shown in FIGS. 1 and 2.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

### [Description of Symbols]

1000: Battery Pack
100: Battery Module
200: Battery Data Management Apparatus
210: Communication Module
220: Controller
300: Relay
2000: Computing System
2100: MCU
2200: Memory
2300: Input/Output I/F
2400: Communication I/F

## Claims

1. A battery data management apparatus comprising:
a communication module configured to receive battery data from a vehicle; and
a controller configured to generate voltage change information with respect to state of charge (SOC)-specific charging/discharging rate (C-rate) by dividing the battery data based on an SOC range and generate open circuit voltage (OCV) change information with respect to an SOC by using the voltage change information with respect to the SOC-specific charging/discharging rate.

2. The battery data management apparatus of claim 1, wherein the communication module is further configured to receive the battery data from a data collecting device that collects the battery data of the vehicle.

3. The battery data management apparatus of claim 2, wherein the controller is further configured to arrange the battery data at specific intervals based on the SOC by applying interpolation to the battery data.

4. The battery data management apparatus of claim 3, wherein the controller is further configured to generate an SOC-specific data group by dividing the battery data based on an SOC range and generate voltage change information according to the SOC-specific charging/discharging rate by fitting each SOC-specific data group.

5. The battery data management apparatus of claim 4, wherein the controller is further configured to calculate the SOC-specific OCV by extracting an OCV that is a voltage value for a charging/discharging rate of '0' from the voltage change information according to the SOC-specific charging/discharging rate.

6. The battery data management apparatus of claim 5, wherein the controller is further configured to generate OCV change information with respect to the SOC by processing an OCV included in the voltage change information according to the SOC-specific charging/discharging rate.

7. The battery data management apparatus of claim 6, wherein the controller is further configured to generate OCV change information with respect to the SOC by inputting the SOC-specific OCV to a window filter to smooth the SOC-specific OCV.

8. An operating method of a battery data management apparatus, the operating method comprising:
receiving battery data from a vehicle;
generating voltage change information with respect to a state of charge (SOC)-specific charging/discharging rate C-rate by dividing the battery data based on an SOC range; and
generating open circuit voltage (OCV) change information with respect to an SOC by using the voltage change information with respect to the SOC-specific charging/discharging rate.

9. The operating method of claim 8, wherein the receiving of the battery data from the vehicle comprises receiving the battery data from a data collecting device that collects the battery data of the vehicle.

10. The operating method of claim 9, wherein the generating of the voltage change information with respect to the SOC-specific charging/discharging rate (C-rate) by dividing the battery data based on the SOC range comprises arranging the battery data at specific intervals based on the SOC by applying interpolation to the battery data.

11. The operating method of claim 10, wherein the generating of the voltage change information with respect to the SOC-specific charging/discharging rate (C-rate) by dividing the battery data based on the SOC range comprises generating an SOC-specific data group by dividing the battery data based on the SOC range and generate voltage change information according to the SOC-specific charging/discharging rate by fitting each SOC-specific data group.

12. The operating method of claim 11, wherein the generating of the voltage change information with respect to the SOC-specific charging/discharging rate (C-rate) by dividing the battery data based on the SOC range comprises calculating the SOC-specific OCV by extracting an OCV that is a voltage value for a charging/discharging rate of '0' from the voltage change information according to the SOC-specific charging/discharging rate.

13. The operating method of claim 12, wherein the generating of the voltage change information with respect to the SOC-specific charging/discharging rate (C-rate) by dividing the battery data based on the SOC range comprises generating OCV change information with respect to the SOC by processing an OCV included in the voltage change information according to the SOC-specific charging/discharging rate.

14. The operating method of claim 13, wherein the generating of the voltage change information with respect to the SOC-specific charging/discharging rate (C-rate) by dividing the battery data based on the SOC range comprises generating OCV change information with respect to the SOC by inputting the SOC-specific OCV to a window filter to smooth the SOC-specific OCV.
